(19) **Europäisches Patentamt**
**European Patent Office**
**Office européen des brevets**

(11) **EP 3 751 342 A1**

(12) **EUROPEAN PATENT APPLICATION**

(43) Date of publication:
**16.12.2020 Bulletin 2020/51**

(51) Int Cl.:
**G03F 1/84** (2012.01)        **G01N 21/956** (2006.01)
**G03F 7/20** (2006.01)        **G06T 7/00** (2017.01)
**G03H 1/04** (2006.01)

(21) Application number: **19179972.5**

(22) Date of filing: **13.06.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
• **Stichting VU**
**1081 HV Amsterdam (NL)**
• **ASML Netherlands B.V.**
**5500 AH Veldhoven (NL)**

• **Stichting Nederlandse Wetenschappelijk**
**3527 JP Utrecht (NL)**
• **Universiteit van Amsterdam**
**1012 WX Amsterdam (NL)**

(72) Inventors:
• **TENNER, Vasco Tomas**
**1081 HV Amsterdam (NL)**
• **COENE, Willem Marie Julia Marcel**
**5500 AH veldhoven (NL)**

(74) Representative: **ASML Netherlands B.V.**
**Corporate Intellectual Property**
**P.O. Box 324**
**5500 AH Veldhoven (NL)**

(54) **METROLOGY METHOD AND METHOD FOR TRAINING A DATA STRUCTURE FOR USE IN METROLOGY**

(57) Disclosed is a method of determining a complex-valued field relating to a structure, comprising: obtaining image data relating to a series of images of the structure, for which at least one measurement parameter is varied over the series and obtaining a trained network operable to map a series of images to a corresponding complex-valued field. The method comprises inputting the image data into said trained network and non-iteratively determining the complex-valued field relating to the structure as the output of the trained network. A method of training the trained network is also disclosed.

Fig. 10

EP 3 751 342 A1

**Description**

FIELD

The present invention relates to a metrology apparatus or an inspection apparatus for determining a characteristic of structures on a substrate. The present invention also relates to a method for determining a characteristic of structures on a substrate.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable to make frequently measurements of the structures created, e.g., for process control and verification. Various tools for making such measurements are known, including scanning electron microscopes or various forms of metrology apparatuses, such as scatterometers. A general term to refer to such tools may be metrology apparatuses or inspection apparatuses.

A metrology device may use computationally retrieved phase to improve aberration performance of an image captured by the metrology device. To help calculate phase, it is helpful to obtain a number of diverse images, such as multiple images of the same target under different focus conditions.

SUMMARY

It is an object to reduce acquisition time and increase throughput when performing a complex field measurement using images comprising focus diversity.

Embodiments of the invention are disclosed in the claims and in the detailed description.

In a first aspect of the invention there is provided a method of determining a complex-valued field relating to a structure, comprising: obtaining image data relating to a series of images of the structure, for which at least one measurement parameter is varied over the series; obtaining a trained network operable to map a series of images to a corresponding complex-valued field; inputting said image data into said trained network; and non-iteratively determining the complex-valued field relating to the structure as the output of the trained network.

In a second aspect of the invention there is provided a method of training an untrained network to obtain a trained network being operable to map a series of images to a corresponding complex-valued field, the training step comprising: obtaining training data relating to a series of holographic measurements of one or more training structures, for which at the least one measurement parameter is varied over the series; extracting sideband data and central band data from said training data; determining complex-valued field data from said sideband data; and using the central band data and corresponding complex-valued field data to train the untrained network to directly map the central band data to the complex-valued field.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;

- Figure 4 is a schematic illustration of a scatterometry apparatus;
- Figure 5 is a schematic illustration of (a) a metrology apparatus employing holography techniques; and (b) an arrangement for providing illumination radiation and reference radiation for use in the metrology apparatus of Figure 5(a);
- Figure 6 schematically illustrates the partitioning of a Fourier transform of an off-axis hologram in terms of a Central Band and Sidebands;
- Figure 7 schematically illustrates a phase measurement using a known holography technique via a single hologram;
- Figure 8 schematically illustrates a phase retrieval for a through-focus image series (with N images) based on a known iterative technique;
- Figure 9 schematically illustrates a through-focus hologram series with both central band and sideband information, the sideband directly yielding the complex-valued sample wavefront;
- Figure 10 schematically illustrates a machine learning training step according to an embodiment of the invention, for training as machine learning network to directly map a through-focus image series to a complex-valued sample wavefront; and
- Figure 11 schematically illustrates a metrology step according to an embodiment of the invention, which utilizes the machine learning network to directly map a through-focus image series to a complex-valued sample wavefront.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

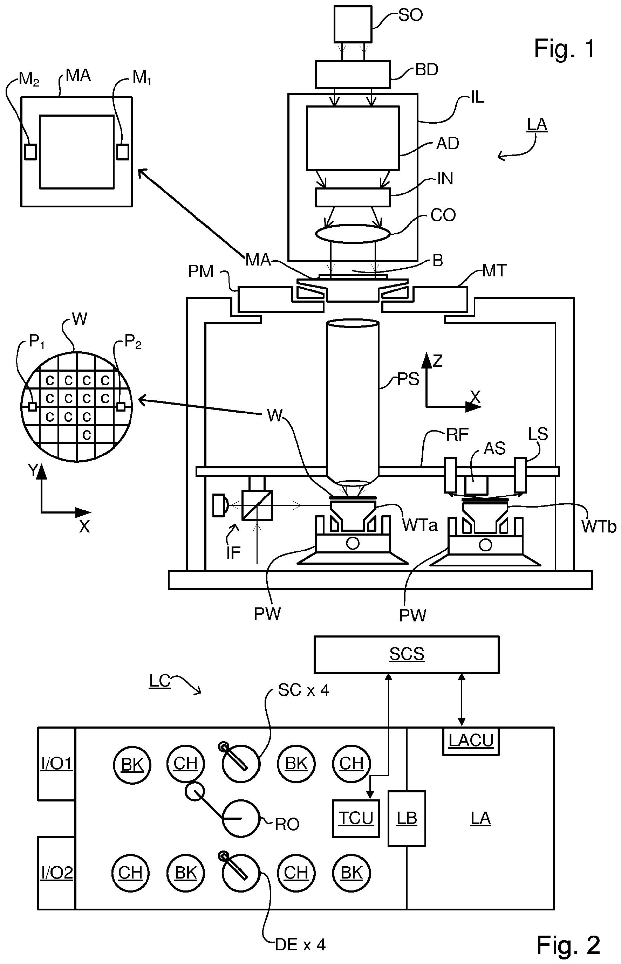

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, 1/02, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

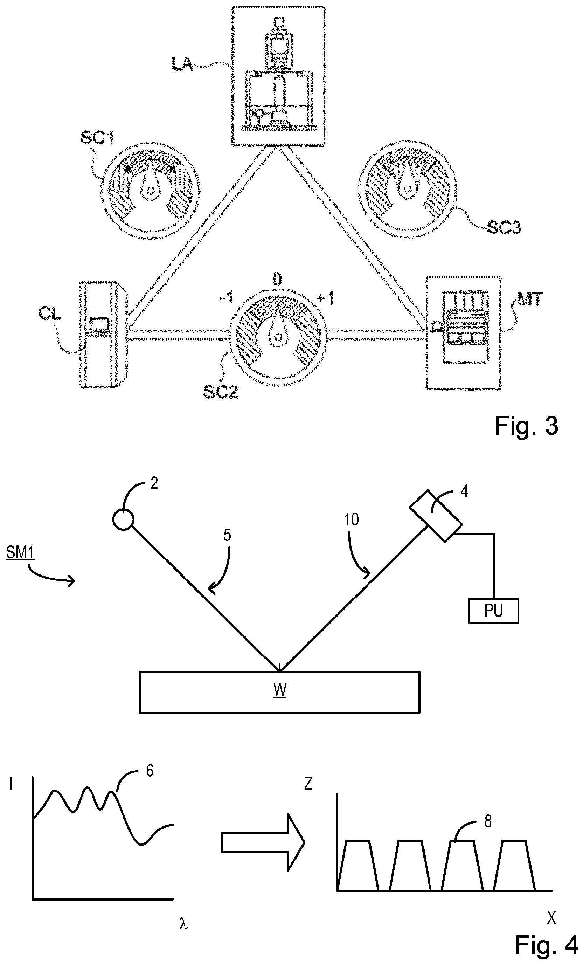

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from from multiple gratings using light from soft x-ray and visible to near-IR wave range.

A metrology apparatus, such as a scatterometer, is depicted in Figure 4. It comprises a broadband (white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation 10. From this data, the structure or profile 8 giving rise to the detected spectrum may be reconstructed by processing unit PU, e.g. by Rigorous Coupled Wave Analysis and non-linear regression or by comparison with a library of simulated spectra. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety

A metrology apparatus which employs a computational imaging/phase retrieval approach has been described in US patent publication US2019/0107781, which is incorporated herein by reference. Such a metrology device may use relatively simple sensor optics with unexceptional or even relatively mediocre aberration performance. As such, the sensor optics may be allowed to have aberrations, and therefore produce a relatively aberrated image. Of course, simply allowing larger aberrations within the sensor optics will have an unacceptable impact on the image quality unless something is done to compensate for the effect of these optical aberrations. Therefore, computational imaging techniques are used to compensate for the negative effect of relaxation on aberration performance within the sensor optics.

In such an approach, the intensity and phase of the target is retrieved from one or multiple intensity measurements of the target. The phase retrieval may use prior information of the metrology target (e.g., for inclusion in a loss function that forms the starting point to derive/design the phase retrieval algorithm). Alternatively, or in combination with the prior information approach, diversity measurements may be made. To achieve diversity, the imaging system is slightly altered between the measurements. An example of a diversity measurement is through-focus stepping, i.e., by obtaining measurements at different focus positions. Alternative methods for introducing diversity include, for example, using different illumination wavelengths or a different wavelength range, modulating the illumination, or changing the angle of incidence of the illumination on the target between measurements.

The phase retrieval itself may be based on that described in the aforementioned US2019/0107781, or in patent application EP17199764 (also incorporated herein by reference). This describes determining from an intensity measurement, a corresponding phase retrieval such that interaction of the target and the illumination radiation is described in terms of its electric field or complex field ("complex" here meaning that both amplitude and phase information is present). The intensity measurement may be of lower quality than that used in conventional metrology, and therefore may be out-of-focus as described. The described interaction may comprise a representation of the electric and/or magnetic field immediately above the target. In such an embodiment, the illuminated target electric and/or magnetic field image is modelled as an equivalent source description by means of infinitesimal electric and/or magnetic current dipoles on a (e.g., two-dimensional) surface in a plane parallel with the target. Such a plane may, for example be a plane immediately above the target, e.g., a plane which is in focus according to the Rayleigh criterion, although the location of the model plane is not critical: once amplitude and phase at one plane are known, they can be computationally propagated to any other plane (in focus, out of focus, or even the pupil plane). Alternatively, the description may comprise a complex transmission of the target or a two-dimensional equivalent thereof.

The phase retrieval may comprise modeling the effect of interaction between the illumination radiation and the target on the diffracted radiation to obtain a modelled intensity pattern; and optimizing the phase and amplitude of the electric field/complex field within the model so as to minimize the difference between the modelled intensity pattern and the detected intensity pattern. More specifically, during a measurement acquisition, an image (e.g., of a target) is captured on detector (at a detection plane) and its intensity measured. A phase retrieval algorithm is used to determine the amplitude and phase of the electric field at a plane for example parallel with the target (e.g., immediately above the target). The phase retrieval algorithm uses a forward model of the sensor (e.g. aberrations are taken into account), to computationally image the target to obtain modelled values for intensity and phase of the field at the detection plane. No target model is required. The difference between the modelled intensity values and detected intensity values is minimized in terms of phase and amplitude (e.g., iteratively) and the resultant corresponding modelled phase value is deemed to be the retrieved phase. Specific methods for using the complex field in metrology applications are described in PCT application PCT/EP2019/052658, also incorporated herein by reference.

The required information for retrieving the phase may come from the diversity (multiple diverse measurements or images). Alternatively, or in combination, prior (target) knowledge may be used to constrain the phase retrieval algorithm. The prior knowledge, for example, may be included in a loss function that forms the starting point to derive/design the phase retrieval algorithm. In such an embodiment, the prior knowledge may be based on certain observations; for example there is much regularity between each image of the multiple images of the target. The multiple images may be obtained in a single measurement (e.g., a measurement using more than one illumination condition, e.g., a multi-wavelength measurement) or from the diversity measurements (different focus levels etc.) already described. It can be observed that, for each image, the target comprises essentially a similar form. In particular, each obtained target image has the same or a very similar position and shape for each region of interest. For example, where the target is a x and y direction compound target, having a general form of a presently used DBO target, each image will generally comprise a region of relatively high intensity having a relatively flat intensity profile corresponding to the position of each target making up the compound target (e.g., a relatively flat intensity profile in each quadrant of a larger square pattern). This similarity between images may be exploited, for example, by means of a generalization of a Total Variation or Vector Total Variation regularization (i.e., imposing an L1 penalty on the gradient of the target image). A benefit of this vector generalization is that it introduces a coupling between e.g., different illumination conditions.

As an alternative to imposing (e.g., focus) diversity over multiple images, phase retrieval or other direct phase measurement may be effected via holography (e.g. single-shot off-axis holography, or multishot in-line holography). Holography, in general terms, describes the calculation of a complex field of radiation from an interference pattern formed by interfering reference radiation with radiation scattered from an object. Further details about how to perform such calculations in the context of lithography for metrology may be found for example in US2016/0061750A1 and PCT/EP2019/056776, both of which are hereby incorporated by reference.

A main drawback with focus-variation phase-retrieval via diversity is that it is an iterative procedure, where the complex-valued sample wavefront is retrieved through minimization of a cost-functional for the recorded focal image series at hand. This is computationally intensive and takes a long time. However, present holography-based direct phase measurement suffers from mechanical sensitivities which might hamper high-speed application in high-volume metrology.

To address these issues, it is proposed to combine the aforementioned holography and through-focus phase-retrieval techniques via a machine-learning (ML) approach. As such, a two-stage method is proposed comprising a first stage or training stage and a second stage or metrology stage. During the training stage, a through-focus hologram series, comprising a plurality of holograms, is used in a recipe set-up phase to train the ML algorithm (where speed of acquisition is no issue, and mechanical sensitivities can be properly mitigated by severely reducing the throughput of measurements). The trained network will be capable of reconstructing the targets in a direct, e.g. non-iterative, approach. For the (e.g., high-volume) metrology stage, the trained ML-algorithm replaces the iterative through-focus phase-retrieval algorithm when performing measurements.

The remaining description will be described in the context of off-axis holography, but is not so restricted. In-line holography using a reference arm which is varied in-phase through variation in z-position is also applicable.

Example Holographic Setup

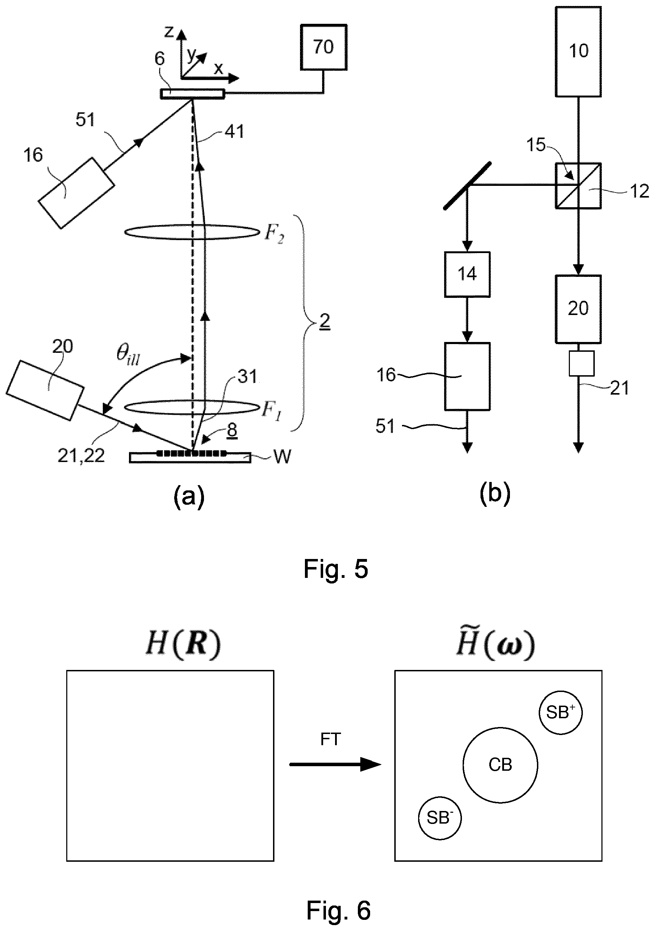

Figure 5(a) depicts a metrology apparatus suitable for determining a characteristic of a structure 8 (e.g. overlay) manufactured on a substrate W according to embodiments of the disclosure. In an embodiment, the metrology apparatus comprises an illumination branch configured to illuminate the structure 8 with illumination radiation 21. The illumination by the illumination radiation 21 generates scattered radiation 31. The metrology apparatus comprises a detection branch. The detection branch comprises an optical system 2 for guiding a portion 41 of the scattered radiation 31 from the structure 8 to a sensor 6. The portion 41 of the scattered radiation 31 is thus the portion of the scattered radiation 31 that reaches the sensor 6. Other portions of the scattered radiation 41 do not reach the sensor 6. In an embodiment, the portion 41 of the scattered radiation 31 reaching the sensor 6 excludes a specular reflection component of the scattered radiation 31. This may be achieved by arranging for a polar angle of incidence of the illumination radiation 21 to be large enough to ensure that the specular reflection, which will occur at the same polar angle of incidence as the illumination, falls outside of a numerical aperture (NA) of the optical system 2. The sensor 6 thus makes a dark field measurement. In an embodiment, the portion 41 of the scattered radiation 31 consists at least predominantly of (i.e. more than half of or completely of) one or more non-zeroth order diffraction components, for example a +1 order diffraction component only or one or more of a +1, +2, +3 or higher order positive non-zeroth order diffraction component, scattered from the structure 8.

The sensor 6 is capable of recording a spatial variation of radiation intensity. The sensor 6 may comprise a pixelated image sensor such as a CCD or CMOS. In an embodiment, a filter is provided that filters radiation impinging on the sensor 6. In an embodiment, the filter is a polarizing filter. In an embodiment, the sensor 6 is positioned in an image plane (which may also be referred to as a field plane) of the optical system 2. The sensor 6 thus records a spatial variation of radiation intensity in the image plane (field plane). In other embodiments, the sensor 6 is positioned in a pupil plane of the optical system 2, in a plane conjugate with the pupil plane of the optical system 2, or in a plane between the pupil plane and the image plane.

In an embodiment, the optical system 2 has a low NA, defined as the NA being lower than 0.3, optionally lower than 0.2. In an embodiment, the optical system 2 comprises a planoconvex lens. The planoconvex lens is isoplanatic and has relatively high aberrations. In an embodiment, the optical system 2 comprises a planoasphere lens or a bi-asphere lens. The planoasphere is non-isoplanatic and has relatively low aberrations. In an embodiment, the optical system 2 comprises mirror optics. In an embodiment, the optical system 2 has a high NA. defined as the NA being higher than 0.5, optionally higher than 0.65, optionally higher than 0.8.

In an embodiment, the detection branch further directs reference radiation 51 onto the sensor 6 at the same time as the portion 41 of the scattered radiation 31. In an embodiment, the reference radiation 51 comprises a plane wave or a spherical wave. A interference pattern is formed by interference between the portion 41 of the scattered radiation 31 reaching the sensor 6 and the reference radiation 51. The portion 41 of the scattered radiation 31 reaching the sensor 8 is at least sufficiently coherent at the sensor 8 with the reference radiation 51 for the interference pattern to be formed and for the interference pattern to be detectable by the sensor 6. The interference pattern is recorded by the sensor 6.

Figure 5(b) depicts a schematic representation of an example arrangement for providing the illumination radiation 21 and the reference radiation 51 for use in the metrology apparatus of Figure 5(a). A radiation source 10 provides a radiation beam to a beam splitter 12. The radiation source 10 generates a radiation beam of temporally and spatially coherent, or temporally and spatially partially coherent, or temporally coherent and spatially partially incoherent electromagnetic radiation (but sufficiently coherent for interference to take place at the sensor 6). In an embodiment, the radiation beam has a wavelength in the visible wavelength range. In an embodiment, the radiation beam has a wavelength in the infrared wavelength range. In an embodiment, the radiation beam has a wavelength in the ultraviolet wavelength range. In an embodiment, the radiation beam has a wavelength in the deep ultraviolet (DUV) wavelength range. In an embodiment, the radiation beam has a wavelength in the range between the infrared wavelength range and the DUV wavelength range. In an embodiment, the radiation beam has a wavelength in the extreme ultraviolet (EUV) wavelength range. In an embodiment, the radiation source 10 is configured to generate radiation at a controllable wavelength. In an embodiment, the radiation source 10 comprises a filtering unit for generating the radiation of a controllable wavelength from radiation having a broadband spectral distribution.

The radiation beam is split by the beam splitter 12 to provide illumination radiation and reference radiation. In the example shown, a part of the split radiation beam, representing reference radiation, passes through a delay element 14 and a reference optical unit 16. The reference optical unit 16 directs the reference radiation 51 onto the sensor 6. In some embodiments, the reference optical unit 16 receives the reference radiation 51 before directing the radiation onto the sensor 6 and may therefore be referred to as a reception unit. A second part of the split radiation beam, representing illumination radiation, passes through an illumination optical unit 20. The illumination optical unit 20 directs the illumination radiation 21 onto the structure 8. An optical path length between a point 15 where the radiation beam is split by the beam splitter 12 and the sensor 6 may be adjusted by the delay element 14. The delay element 14 may comprise any suitable arrangement for introducing a phase delay, for example by controllably increasing a path length of the radiation passing through the delay element 14. In the present example, the delay element 14 is provided in the optical path between the beam splitter 12 and the reference optical unit 16, but a delay element 14 could alternatively or additionally be provided in the optical path between the beam splitter 12 and the illumination optical unit 20.

## Central Band and Sidebands of a Hologram

An off-axis hologram is realized through interference of an image-plane wavefront (essentially the sample wavefront, but also comprising the effect of aberrations of the imaging lens) and a reference wavefront, where both image-plane and reference wavefronts make an angle with respect to each other. The reference wavefront can typically be a (e.g., tilted) plane wave in off-axis holography. The hologram is a 2D image that comprises different elements of the interference of the image-plane wavefront and the reference wavefront. The so-called central band (CB) comprises the auto-correlation (due to auto-interference of that wavefront) of the image-plane wavefront, together with the autocorrelation of the reference wavefront (due to auto-interference of that wavefront). The so-called sidebands (SB$^+$ and SB$^-$) comprise the interference of reference wavefront with the image-plane wavefront, and *vice versa,* respectively.

Figure 6 shows the concept of the central band CB and sidebands SBs in the Fourier transform FT of an off-axis hologram $H(\boldsymbol{R})$ (where $\tilde{H}(\omega)$ is the Fourier transformation of hologram $H(\boldsymbol{R})$). It should be noted that the CB (apart from the autocorrelation of the reference wavefront) carries the same information as that of a regular image; i.e., as would be obtained if the holographic interference was switched off, e.g., by blocking the reference arm. Furthermore, the CB is the autocorrelation of the SB. For phase measurement in regular holography, information from only one of the sidebands SB$^+$, SB$^-$ is typically used (the two sidebands SB$^+$, SB$^-$ comprise identical information and show inversion symmetry since

$$\widetilde{SB}^+(-\bar{\boldsymbol{v}}) = \widetilde{SB}^-(+\bar{\boldsymbol{v}})$$ with $\bar{\boldsymbol{v}}$ the 2D spatial frequency vector in Fourier space) and the CB information is typically discarded.

## Phase Measurement in Holography

For direct phase measurement of the image-plane wavefront in (off-axis) holography, one of the sidebands is used. The separation of one of the sidebands from the central band and the other sideband may be performed via Fourier transformation of the hologram. In the 2D Fourier space, the CB, SB+ and SB-are spatially separated; the amount of spatial separation being determined by the tilt of the reference wavefront relative to the image-plane wavefront. It should be noted that the two sidebands do carry exactly the same information (including noise), which results from the point inversion property of the Fourier transform of a real-valued hologram.

The complex-valued wavefront of the sideband SB+, (i.e., the image-plane wavefront), is the multiplication of the non-aberrated sample wavefront with the transfer function (typically comprising a phase-aberration function) of the imaging lens (or objective). Deconvolution for the transfer function is simply performed in Fourier space by division of the SB+ wavefront by the latter transfer function, or in case of a phase-only transfer function, by multiplication with the complex conjugate of the transfer function. It should be noted that acquisition of one single (off-axis) hologram is sufficient for direct phase measurement (diversity is not required), which is simply achieved by spatial separation of one of the SBs in the 2D Fourier space of the hologram.

Note that the concepts described herein are equally applicable to other regimes than off-axis holography, and any suitable method (appropriate for the set-up) can be used to separate sidebands and central band (e.g., phase shifting or DC term removal). The skilled person will readily know how to adapt the teaching herein to other regimes.

## Through-Focus Hologram Series

The application of additional diversity to the hologram, leads to a series of holograms, each hologram being captured at a different setting for one or more optical imaging parameters. For example, the one or more optical imaging parameters may comprise focus, such that (e.g., only) the focus setting is varied between holograms. Considering a particular case of a through-focus hologram series, recorded at focus settings denoted $f_n$, where the nth hologram is denoted $H_n(\boldsymbol{R},f_n)$, and where $\boldsymbol{R}$ is the 2D position coordinate in the plane of the detector. It is convenient to consider its Fourier transform $\tilde{H}_n(\omega,f_n)$, where $\omega$ is the 2D coordinate in the Fourier plane. Each hologram is subject to a transfer function for imaging, which is denoted as $\tilde{P}_n(\omega,f_n)$.

It should be noted that a through-focus hologram series also comprises, for each of its central bands (denoted in the Fourier plane as $\widetilde{CB}_n(\omega,f_n)$), the data of a regular through-focus series (i.e., as would be recorded without using the reference wavefront).

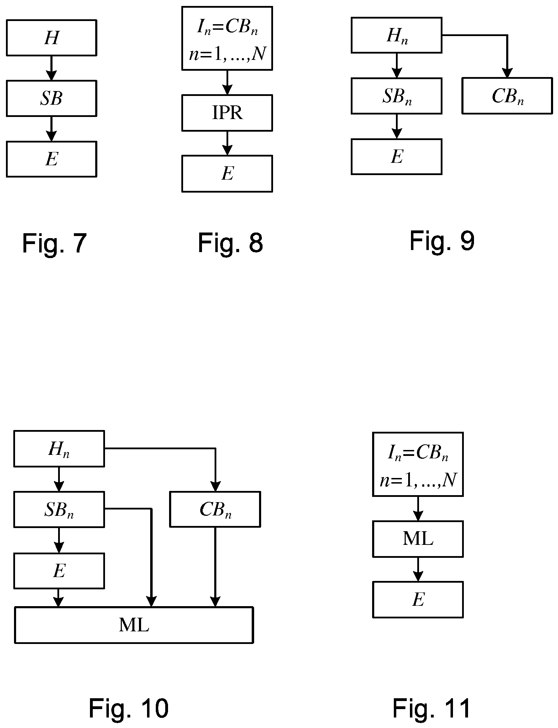

A flow diagram representing a direct phase measurement is shown schematically in Figure 7. A hologram $H$ relating to a sample (e.g., target) is obtained, a sideband $SB$ is processed as described above and the complex-valued sample wavefront $E$ is determined. A schematic representation of a regular, iterative through-focus phase retrieval is shown in Figure 8. A (non-holographic) through-focus intensity series $I_n$ (where $n$ is the focal index), which is equivalent to the data comprised in a through-focus central band series $CB_n$ of a holographic measurement, undergoes an iterative phase retrieval IPR step (such as described in US2019/0107781) to determine the sample wavefront E. Figure 9 illustrates the information comprised within a through-focus hologram series $H_n$, showing both the direct phase measure-

ment via the sidebands $SB_n$ leading to the sample wavefront $E$, with the central bands $CB_n$ representing the regular through-focus image series which is comprised within the hologram series.

The concept proposed herein comprises applying a machine-learning based phase-retrieval step which maps a measured through-focus image series onto a desired complex-valued sample wavefront, where the machine-learning network (or more generally: algorithm or data structure) is trained on a (measured or simulated) hologram series. The machine-learning (ML) based algorithm can be, for example, a deep-learning network, or an auto-encoder/decoder network or any other suitable machine learning network or data structure.

The ML approach comprises the usual two steps, (1) a training step, and (2) a metrology step or high volume metrology (HVM) ML-phase-retrieval step. In the training step, a number of through-focus hologram series are recorded; these are then used as input to train an ML network such as a deep-learning network or auto-encoder/decoder. For the second step, a through-focus image series is input to the trained ML algorithm/network, which maps the through-focus image series to the desired complex-valued sample wavefront.

## Step 1: Training

The training step may comprise training an untrained data structure or network using training data relating to a series of holographic measurements (e.g., through-focus hologram series $H_n$) of one or more training structures (e.g., targets or samples), for which at the least one measurement parameter (e.g., focus) is varied over the series. The method may comprise the following steps: extracting sideband data (e.g., sidebands $SB_n$) and central band data (e.g., through-focus central bands $CB_n$) from said training data; determining complex-valued field data (e.g., sample complex-valued wavefronts $E$) from said sideband data; and using the central band data and corresponding complex field data to train the untrained network to directly map the central band data to the complex field.

More specifically, the training step uses a number of measured (and/or simulated) through-focus hologram series $H_n$. From each hologram series $H_n$, both the through-focus central bands $CB_n$ (more specifically,

in the Fourier plane: $\widetilde{CB}_n(\omega, f_n))$ and the corresponding sample wavefront $E$ as determined directly from the sidebands $SB_n$ are known.

Figure 10 illustrates schematically how this data may be used for training the ML network. The training step ML comprises training the ML network so that it can map the through-focus central band data $CB_n$ to the sample wavefront $E$ based on the known mapping of the corresponding sideband data $SB_n$ (i.e., from the same holograms) to the sample wavefront $E$.

It should be noted that the processing of the sidebands $SB_n$ to the complex-valued sample wavefront $E$ can be done in two ways: (a) a simple direct determination; or (b) including a step for aberration correction, by dividing out the phase-transfer function from the sideband. It should further be noted that the processing of the sidebands $SB_n$ to the complex-valued sample wavefront $E$ can be applied on a single hologram, a few holograms or the complete series of holograms (with N holograms in the full series). The latter approach may be beneficial in terms of the signal-to-noise ratio (SNR).

In the case of perfect reconstruction of the complex field data from the sideband data, the sideband data has no additional value. When this reconstruction is not perfect, there will be additional information in the sideband data compared to the corresponding complex field. As such, in an optional embodiment, the sideband data can be used in the main training step additionally to the complex field data.

## Step 2 High Volume (HV) Metrology

The HV metrology step comprises obtaining image data relating to a series of images of a structure, for which at least one measurement parameter (e.g., focus) is varied over the series and inputting said series of images of the structure into the trained network so as to non-iteratively determine the complex field relating to the structure.

The HV metrology step comprises an ML-based, direct phase-retrieval based on a through-focus image series. After the training in Step 1, the trained ML network can be applied to a measured through-focus image series $I_n/CB_n$ so as to map it to the sample wavefront $E$ (e.g., the complex or full electric field). This is shown schematically in Figure 11. The trained ML network replaces the regular iterative through-focus phase-retrieval approach of Figure 8. This step may be performed using the holography apparatus used in step 1 (training phase) to perform through-focus measurements of a sample/target, but without reference radiation/ a reference wavefront. This may be achieved by performing the measurements to obtain through-focus image series $I_n/CB_n$ with the reference side arm (e.g., reference optical unit 16 in Figure 5) disabled (or blocked), in contrast to step 1 where the reference side arm is enabled (or unblocked). The trained network is trained for a specific apparatus configuration and learns how the light propagates through this specific setup. As such, it is preferable that aberrations etc. are the same between the training set-up and HV metrology set-up. However, it is possible (and within the scope of this disclosure) that the trained network may work on metrology set-ups which are not the same (e.g., same model) or substantially the same as that on which it was trained, particularly if similar. The spatial coherence characteristics are required to be the same between the training set-up and HV metrology set-up.

Therefore, disclosed herein is a method where a (measured or simulated) through-focus hologram series is used in a training step to train a ML network so that it can directly (i.e., non-iteratively) map a through-focus intensity (unreferenced) series to its corresponding complex electric field. The trained ML algorithm can then be used in high-volume metrology (HVM) for mapping an experimentally recorded through-focus image series of one or more targets (e.g., μDBO type targets) onto a complex-valued sample wavefront. The training data used in the training step may comprise a through-focus hologram series which contains both regular image information and sideband (e.g., referenced) information, the latter yielding directly the complex-valued sample wavefront which is to be trained as the output of the ML algorithm. A main benefit of using a ML approach is that this allows faster reconstruction than an iterative approach such as is commonly used in interferometry, in order to be less sensitive for measurement noise.

Further embodiment are disclosed in the subsequent numbered clauses:

1. A method of determining a complex-valued field relating to a structure, comprising:

obtaining image data relating to a series of images of the structure, for which at least one measurement parameter is varied over the series;
obtaining a trained network operable to map a series of images to a corresponding complex-valued field; inputting said image data into said trained network; and
non-iteratively determining the complex-valued field relating to the structure as the output of the trained network.

2. A method as defined in clause 1, wherein the image data has been obtained from a unreferenced optical measurement.

3. A method as defined in clause 2, wherein the unreferenced optical measurement was performed using a holographic apparatus for which a reference branch was disabled.

4. A method as defined in any preceding clause, comprising performing one or more optical measurements to obtain said image data.

5. A method as defined in any preceding clause, wherein the trained network is a neural network or an auto-encoder/decoder network.

6. A method as defined in any preceding clause, wherein the trained network has been trained on training data relating to a series of holographic measurements of one or more training structures, for which at the least one measurement parameter is varied over the series.

7. A method as defined in clause 6, wherein an apparatus used to obtain the image data and the an apparatus used to obtain the training data is a similar or the same holographic apparatus, comprising a reference branch for providing reference radiation; and wherein:

said image data is obtained from unreferenced optical measurements performed with the reference branch disabled, and
said training data is obtained from referenced optical measurements performed with the reference branch enabled.

8. A method as defined in clause 6 or 7, comprising a training step to train an untrained network to obtain the trained network, the training step comprising:

extracting sideband data and central band data from said training data;
determining complex-valued field data from said sideband data; and
using central band data and corresponding complex-valued field data to train the untrained network to directly map the central band data to the complex-valued field.

9. A method as defined in clause 8, wherein said training step comprises an initial correction for optical aberration in the training data or sideband data prior to said step of determining the complex-valued field.

10. A method as defined in any of clauses 6 to 9, wherein said training data exclusively or partially comprises simulated holographic measurements.

11. A method as defined in any of clauses 6 to 10, comprising the step of performing and/or simulating the holographic measurements to obtain said training data.

12. A method as defined in any preceding clause, wherein the at least one measurement parameter comprises focus.

13. A method of training an untrained network to obtain a trained network being operable to map a series of images to a corresponding complex-valued field, the training step comprising:

obtaining training data relating to a series of holographic measurements of one or more training structures, for which at the least one measurement parameter is varied over the series;
extracting sideband data and central band data from said training data;
determining complex-valued field data from said sideband data; and
using the central band data and corresponding complex-valued field data to train the untrained network to directly map the central band data to the complex-valued field.

14. A method as defined in clause 13, wherein said training data exclusively or partially comprises simulated holographic measurements.

15. A method as defined in clause 13 or 14, comprising the step of performing and/or simulating the holographic measurements to obtain said training data.

16. A data structure comprising the trained network resultant from performing the method of any of clauses 13 to 15.

17. A data structure carrier comprising the data structure of clause 16.

18. A metrology apparatus configured to determine a characteristic of a structure manufactured on a substrate, comprising:

a data structure comprising a trained network operable to directly map a series of images to a corresponding complex-valued field; and
a processor operable to use said data structure to determine a complex-valued field relating to the structure from image data comprising a series of images of the structure, for which at least one measurement parameter is varied over the series.

19. A metrology apparatus of clause 18 operable to perform the method of any of clauses 1 to 15.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). The term "metrology apparatus" may also refer to an inspection apparatus or an inspection system. E.g. the inspection apparatus that comprises an embodiment of the invention may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch P of the metrology targets may be close to the resolution limit of the optical system of the scatterometer or may be smaller, but may be much larger than the dimension of typical product features made by lithographic process in the target portions C. In practice the lines and/or spaces of the overlay gratings within the target structures may be made to include smaller structures similar in dimension to the product features.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A method of determining a complex-valued field relating to a structure, comprising:

obtaining image data relating to a series of images of the structure, for which at least one measurement parameter is varied over the series;
obtaining a trained network operable to map a series of images to a corresponding complex-valued field;

inputting said image data into said trained network; and

non-iteratively determining the complex-valued field relating to the structure as the output of the trained network.

2. A method as claimed in claim 1, wherein the image data has been obtained from a unreferenced optical measurement.

3. A method as claimed in claim 2, wherein the unreferenced optical measurement was performed using a holographic apparatus for which a reference branch was disabled.

4. A method as claimed in any preceding claim, comprising performing one or more optical measurements to obtain said image data.

5. A method as claimed in any preceding claim, wherein the trained network is a neural network or an auto-encoder/decoder network.

6. A method as claimed in any preceding claim, wherein the trained network has been trained on training data relating to a series of holographic measurements of one or more training structures, for which at the least one measurement parameter is varied over the series.

7. A method as claimed in claim 6, wherein an apparatus used to obtain the image data and the an apparatus used to obtain the training data is a similar or the same holographic apparatus, comprising a reference branch for providing reference radiation; and wherein:

said image data is obtained from unreferenced optical measurements performed with the reference branch disabled, and
said training data is obtained from referenced optical measurements performed with the reference branch enabled.

8. A method as claimed in claim 6 or 7, comprising a training step to train an untrained network to obtain the trained network, the training step comprising:

extracting sideband data and central band data from said training data;
determining complex-valued field data from said sideband data; and
using central band data and corresponding complex-valued field data to train the untrained network to directly map the central band data to the complex-valued field,
and wherein, optionally, said training step comprises an initial correction for optical aberration in the training data or sideband data prior to said step of determining the complex-valued field.

9. A method as claimed in any of claims 6 to 8, wherein said training data exclusively or partially comprises simulated holographic measurements.

10. A method as claimed in any of claims 6 to 10, comprising the step of performing and/or simulating the holographic measurements to obtain said training data.

11. A method as claimed in any preceding claim, wherein the at least one measurement parameter comprises focus.

12. A method of training an untrained network to obtain a trained network being operable to map a series of images to a corresponding complex-valued field, the training step comprising:

obtaining training data relating to a series of holographic measurements of one or more training structures, for which at the least one measurement parameter is varied over the series;
extracting sideband data and central band data from said training data;
determining complex-valued field data from said sideband data; and
using the central band data and corresponding complex-valued field data to train the untrained network to directly map the central band data to the complex-valued field.

13. A method as claimed in claim 12, wherein said training data exclusively or partially comprises simulated holographic measurements.

14. A method as claimed in claim 12 or 13, comprising the step of performing and/or simulating the holographic measurements to obtain said training data.

15. A metrology apparatus configured to determine a characteristic of a structure manufactured on a substrate, comprising:

a data structure comprising a trained network operable to directly map a series of images to a corresponding complex-valued field; and
a processor operable to use said data structure to determine a complex-valued field relating to the structure from image data comprising a series of images of the structure, for which at least one measurement parameter is varied over the series,
and wherein, optionally, the metrology apparatus is operable to perform the method of any of claims 1 to 14.

Fig. 1

Fig. 2

LA

SC1

SC3

0

-1 +1

CL

MT

SC2

Fig. 3

SM1

2

5

10

4

PU

W

I

6

Z

8

λ

X

Fig. 4

Fig. 5

Fig. 6

```
┌─────────┐
│    H    │
└─────────┘
     │
     ▼
┌─────────┐
│   SB    │
└─────────┘
     │
     ▼
┌─────────┐
│    E    │
└─────────┘
```

Fig. 7

```
┌──────────────┐
│  $I_n=CB_n$  │
│ $n=1,...,N$  │
└──────────────┘
        │
        ▼
┌──────────────┐
│     IPR      │
└──────────────┘
        │
        ▼
┌──────────────┐
│      E       │
└──────────────┘
```

Fig. 8

```
┌─────────┐          ┌─────────┐
│  $H_n$  │─────────▶│ $CB_n$  │
└─────────┘          └─────────┘
     │
     ▼
┌─────────┐
│ $SB_n$  │
└─────────┘
     │
     ▼
┌─────────┐
│    E    │
└─────────┘
```

Fig. 9

```
┌─────────┐                ┌─────────┐
│  $H_n$  │───────────────▶│ $CB_n$  │
└─────────┘                └─────────┘
     │                          │
     ▼                          │
┌─────────┐                     │
│ $SB_n$  │──────┐              │
└─────────┘      │              │
     │           │              │
     ▼           │              │
┌─────────┐      │              │
│    E    │      │              │
└─────────┘      │              │
     │           │              │
     ▼           ▼              ▼
┌──────────────────────────────────┐
│               ML                 │
└──────────────────────────────────┘
```

Fig. 10

```
┌──────────────┐
│  $I_n=CB_n$  │
│ $n=1,...,N$  │
└──────────────┘
        │
        ▼
┌──────────────┐
│      ML      │
└──────────────┘
        │
        ▼
┌──────────────┐
│      E       │
└──────────────┘
```

Fig. 11

Europäisches
Patentamt

European
Patent Office

Office européen
des brevets

# EUROPEAN SEARCH REPORT

**Application Number**

EP 19 17 9972

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | NL 2 021 848 A (STICHTING VU [NL] ET AL.) 6 November 2018 (2018-11-06) * abstract * | 1-11,15 | INV. G03F1/84 G01N21/956 G03F7/20 G06T7/00 G03H1/04 |
| E | -& WO 2019/197117 A1 (STICHTING VU [NL] ET AL.) 17 October 2019 (2019-10-17) * paragraphs [0045] - [0052]; figure 4 * | 1-11,15 | |
| A,D | US 2019/107781 A1 (TINNEMANS PATRICIUS ALOYSIUS JACOBUS [NL] ET AL) 11 April 2019 (2019-04-11) * paragraphs [0088] - [0095] * | 1-11,15 | |
| A | YICHEN WU ET AL: "Extended depth-of-field in holographic image reconstruction using deep learning based auto-focusing and phase-recovery", ARXIV.ORG, CORNELL UNIVERSITY LIBRARY, 201 OLIN LIBRARY CORNELL UNIVERSITY ITHACA, NY 14853, 21 March 2018 (2018-03-21), XP081224518, DOI: 10.1364/OPTICA.5.000704 * abstract * * pages 1-3 * | 12-14 | |

TECHNICAL FIELDS
SEARCHED (IPC)

G03F
G06T
G01N
G03H

The present search report has been drawn up for all claims

| Place of search | Date of completion of the search | Examiner |
|---|---|---|
| Munich | 5 December 2019 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## EP 3 751 342 A1

### ANNEX TO THE EUROPEAN SEARCH REPORT
### ON EUROPEAN PATENT APPLICATION NO.

EP 19 17 9972

This annex lists the patent family members relating to the patent documents cited in the above-mentioned European search report.
The members are as contained in the European Patent Office EDP file on
The European Patent Office is in no way liable for these particulars which are merely given for the purpose of information.

05-12-2019

| Patent document cited in search report | | Publication date | Patent family member(s) | | Publication date |
|---|---|---|---|---|---|
| NL 2021848 | A | 06-11-2018 | NL | 2021848 A | 06-11-2018 |
| | | | US | 2019310559 A1 | 10-10-2019 |
| | | | WO | 2019197117 A1 | 17-10-2019 |
| WO 2019197117 | A1 | 17-10-2019 | NL | 2021848 A | 06-11-2018 |
| | | | US | 2019310559 A1 | 10-10-2019 |
| | | | WO | 2019197117 A1 | 17-10-2019 |
| US 2019107781 | A1 | 11-04-2019 | TW | 201925922 A | 01-07-2019 |
| | | | US | 2019107781 A1 | 11-04-2019 |
| | | | WO | 2019068459 A1 | 11-04-2019 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 20100328655 A
- US 2011102753 A1
- US 20120044470 A
- US 20110249244 A
- US 20110026032 A
- EP 1628164 A
- US 11451599 B
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 PCT
- US 20160161863 A
- US 20160370717 A
- US 20190107781 A
- EP 17199764 A
- EP 2019052658 W
- US 20160061750 A1
- EP 2019056776 W